# DEMANDE DE BREVET EUROPEEN

(11) **EP 2 418 608 A1**
(43) Date de publication de la demande: **15.02.2012**
(21) Numéro de dépôt: 10305819.4
(22) Date de dépôt: 23.07.2010
(51) Int. Cl.: G06K 19/077

(54) **Module électronique sécurisé, dispositif à module électronique sécurisé et procédé de fabrication**

(71) Demandeur: Gemalto SA, 92190 Meudon (FR)
(72) Inventeur: DOSSETTO, Lucile, 92197, MEUDON (FR); LESUR, Jean-Luc, 92197, MEUDON (FR); LIMOUSIN, Isabelle, 92197, MEUDON (FR); ROBERTET, Laurence, 92197, MEUDON (FR)
(74) Mandataire: Cour, Pierre

(57) **Abrégé**

La présente invention concerne un module électronique sécurisé (1) comportant un film support diélectrique (3) ayant au moins une zone de contact électrique (5) sur une face, et ayant sur la face opposée une puce électronique (7) reliée à ladite au moins une zone de contact électrique (5) par des connectiques (9) passant par des orifices (11) au travers du film support (3), ledit film support (3) comportant au moins une zone de fragilisation (12).

## Description

La présente invention se rapporte au domaine technique des modules électroniques, aux procédés de fabrication d'un module électronique, ainsi qu'aux dispositifs électroniques, en particulier aux cartes à puces, comportant au moins un module électronique. Plus précisément, l'invention ce rapporte aux modules électroniques sécurisés.

De façon générale, les modules électroniques sont formés par un film support diélectrique sur lequel est laminée une couche métallisée. Sur la face opposée à la couche métallisée est collée une puce électronique connectée à différentes zones de la couche métallisée.
Dans un dispositif électronique, le module électronique est collé dans une cavité prévue à cet effet dans le corps du dispositif.
Ce genre de module électronique trouve application notamment dans les cartes à puces.

Cependant, les normes concernant le paiement électronique notamment par cartes bancaires ou concernant les pièces d'identité électroniques, demandent une plus grande inviolabilité mécanique en particulier le fait que l'on ne puisse retirer le module électronique pour le réutiliser par la suite.
Une solution consiste à réaliser un collage structural ou par ancrage mécanique de la puce dans une résine solidaire du fond de la cavité du corps du dispositif. Ainsi, lors d'une tentative de démontage du module électronique, la puce est solidaire de la résine et reste dans la cavité du corps du dispositif électronique et est donc déconnectée de la couche métallisée. Le démontage du module électronique pour une réutilisation ultérieure est donc rendu impossible.
Cependant, pour certain matériaux de corps de dispositif, comme le polycarbonate (PC) ou le polyéthylène téréphtalate (PET) couramment utilisé actuellement, le collage par résine est plus délicat étant donné une plus faible adhérence et donc les risques de démontage du module électronique pour une utilisation frauduleuse sont plus importants.

Un des buts de la présente invention est donc de proposer un module électronique sécurisé, pouvant être utilisé efficacement avec le plus grand nombre de matériaux de corps de dispositif électroniques possible, tels que les cartes à puces.

Ainsi, la présente invention concerne un module électronique sécurisé comportant un film support diélectrique ayant au moins une zone de contact électrique sur une face, et ayant sur la face opposée une puce électronique reliée à ladite au moins une zone de contact électrique par des connectiques passant par des orifices au travers du film support, ledit film support comportant au moins une zone de fragilisation.
La zone de fragilisation permet une sécurisation du module électronique. En effet lorsque ce dernier est fixé, par exemple sur un dispositif électronique comme une carte à puce, une tentative de démontage dudit module entraine la rupture du film support au niveau de la ou les zones de fragilisation, rendant ainsi ledit module électronique inutilisable par la suite.

Selon un aspect de l'invention, la délimitation de la au moins une zone de fragilisation est située sur une zone non métallisée.
Par zone non métallisée, on entend une zone sur la face comportant au moins une zone de contact électrique, où le film support est à nu.

Selon un autre aspect de l'invention, la délimitation de la au moins une zone de fragilisation est composée au moins en partie d'une ou plusieurs séries d'encoches.

Selon un mode de réalisation de l'invention, la ou les séries d'encoches traversent le film support sur toute son épaisseur.

Selon un autre mode de réalisation de l'invention, la ou les séries d'encoches ont une profondeur inférieure à l'épaisseur du film support.

Selon un autre aspect de l'invention, la ou les série d'encoches ont une largeur de 50 à 100 µm.

Selon un autre aspect de l'invention, la ou les séries d'encoches sont réalisées sur la face opposée à la face comportant la ou les zones de contact électrique du film support.

Selon un autre aspect de l'invention, la ou les séries d'encoches sont réalisées sur la face comportant la ou les zones de contact électrique du film support.

Selon un autre aspect de l'invention, la ou les séries d'encoches sont réalisées par découpe laser.

La présente invention concerne également un dispositif électronique comportant au moins un module électronique sécurisé comprenant un film support diélectrique ayant au moins une zone de contact électrique sur une face, et ayant sur la face opposée une puce électronique reliée à ladite au moins une zone de contact électrique par des connectiques passant par des orifices au travers du film support, ledit film support comportant au moins une zone de fragilisation fixée audit dispositif électronique.

Selon un autre aspect de l'invention, ledit dispositif est une carte à puce.

La présente invention concerne également un procédé de fabrication d'un module électronique sécurisé comportant un film support diélectrique ayant au moins une zone de contact électrique sur une face, et ayant sur la face opposée une puce électronique reliée à ladite au moins une zone de contact électrique par des connectiques passant par des orifices au travers du film support, ledit procédé comprenant une étape de réalisation d'au moins une zone de fragilisation sur le film support.

Selon un autre aspect de l'invention, l'étape de réalisation d'au moins une zone de fragilisation sur le film support est réalisée lors de la fabrication du film support.

Selon un autre aspect de l'invention, l'étape de réalisation d'au moins une zone de fragilisation sur le film support est réalisée en fin du processus de la fabrication du module électronique.

La présente invention concerne également un procédé de fabrication d'un dispositif électronique comportant au moins un module électronique sécurisé comprenant un film support diélectrique ayant au moins une zone de contact électrique sur une face, et ayant sur la face opposée une puce électronique reliée à ladite au moins une zone de contact électrique par des connectiques passant par des orifices au travers du film support, ledit procédé comprenant une étape de réalisation d'au moins une zone de fragilisation sur le film support.

Selon un autre aspect de l'invention, l'étape de réalisation d'au moins une zone de fragilisation sur le film support est réalisée avant la mise en place du module électronique dans un dispositif électronique.

Selon un autre aspect de l'invention, l'étape de réalisation d'au moins une zone de fragilisation sur le film support est réalisée après la mise en place du module électronique dans un dispositif électronique, tel qu'une carte à puce.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente un schéma simplifié d'un exemple de dispositif électronique, en vue de dessus,
- la figure 2 représente un schéma simplifié d'un exemple de module électronique, en vue de coupe longitudinale,
- La figure 3 représente un schéma simplifié d'un exemple de module électronique, en vue de dessous,
- La figure 4 représente un schéma simplifié d'un exemple de module électronique, en vue de dessus.

Les éléments identiques sur toutes les figures sont indiqués par les mêmes numéros de références.

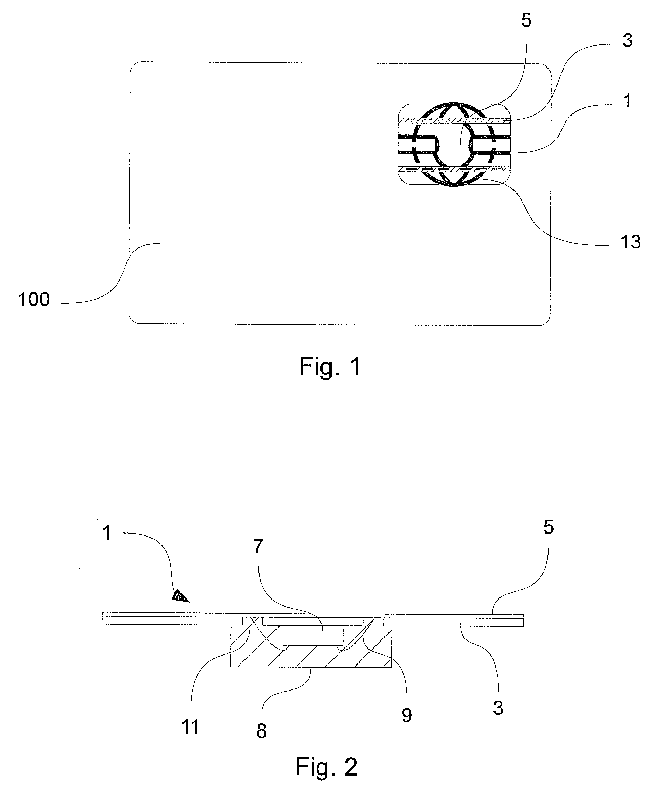

La figure 1 représente un schéma simplifié d'un exemple de dispositif électronique 100, ici une carte à puce, en vue de dessus, dans lequel a été mis en place un module électronique 1.
On y voit, au niveau du module électronique 1, plusieurs zones de contact électrique 5 réalisés par exemples par métallisation sur un film support diélectrique 3. Les zones de contact électrique 5 sont séparées les unes des autres par exemple par des zones ou bandes non métallisées 13. Il s'agit de zones ou bandes où le film support diélectrique 3 est à nu.

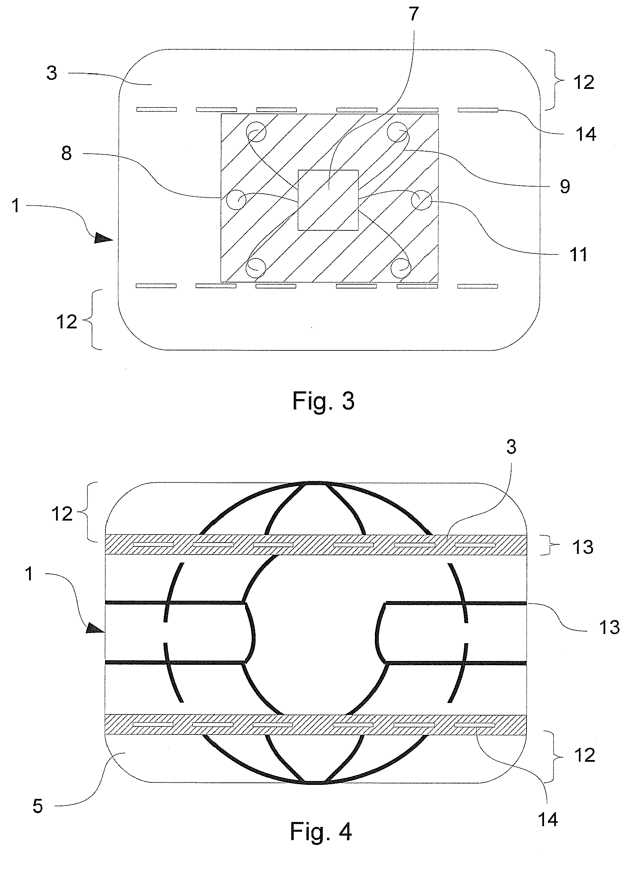

On se réfère maintenant aux figures 2 à 4 qui montrent le module électronique 1 de la figure 1, en vue de coupe et de côté (figure 2), en vue de dessous (figure 3) et en vue de dessus (figure 4).
On retrouve le film support diélectrique 3 sur lequel est ménagée, sur une de ses faces, au moins une zone de contact électrique 5. Une puce électronique 7 est fixée sur le film support 3 sur la face opposée à celle comportant la au moins une zone de contact électrique 5. La puce électronique 7 est reliée aux différentes zones de contact électrique 5 par des connectiques 9 passant au travers du film support 3 par des orifices 11.
La puce électronique 7 ainsi que ses connectiques 9 peuvent être recouverts d'une capsule de résine 8 protectrice.

Afin d'améliorer l'inviolabilité mécanique du module électronique 1, au moins une zone de fragilisation 12 est réalisée sur le film support 3. La ou les parties du film support 3 où est réalisée la au moins une zone de fragilisation 12, sont destinées à se séparer du reste du film support 3 lors d'une tentative de démontage frauduleuse du module électronique 1 lorsque ce dernier est en place dans un dispositif électronique 100, par exemple lorsque le module électronique 1 est encarté dans une carte à puce.
Lors de la mise en place d'un module électronique 1 dans un dispositif électronique 100, le module électronique 1 est fixé à ce dernier par exemple grâce à un adhésif. La ou les zones de fragilisation 12 sont donc également fixées au dispositif électronique 100.
Lors d'une tentative frauduleuse de retirer le module électronique 1 du dispositif électronique 100, ledit module électronique 1 va se briser au niveau des délimitations 14, de la ou des zones de fragilisation 12. La ou les zones de fragilisation 12, étant fixées au dispositif électronique 100, vont rester sur ce dernier alors que le reste du module électronique 1 sera retiré. Le module électronique 1 sera donc inutilisable ultérieurement car brisé, et les zones de fragilisations 12 restantes sur le dispositif électronique peuvent gêner par exemple l'installation ultérieure d'un autre module électronique 1.

Afin de maximiser les effets de fragilisation du film support 3, les délimitations 14 de la ou les zones de fragilisation 12 sont positionnées dans des zones non métallisées 13. En effet, cette caractéristique permet que, lors d'une tentative de démontage du module électronique 1, le film support 3 casse au niveau de ces délimitations 14 de la ou des zones de fragilisation 12 et que la ou les zones de contact électrique 5 ne retienne pas ensemble les parties brisées du film support 3.
La ou des zones de fragilisation 12 peuvent être délimitées pas une ou plusieurs série d'encoches 14, comme représenté sur les figures 3 et 4.
Sur les figures, les séries d'encoches 14 sont représentées agrandies de façon exagérée afin de faciliter la compréhension.

La ou les zones de fragilisation 12 peuvent être délimitées par une ou plusieurs séries d'encoches 14 perforantes, c'est-à-dire traversant de part en part le film support 3, formant ainsi une ligne de fragilisation qui devient une ligne de rupture.

Sur les figures et à titre d'exemple, on voit deux séries d'encoches 14 parallèles et traversant le module électronique 1 de part en part dans le sens longitudinal et situées partiellement au raz de la capsule de résine 8. On obtient donc deux lignes de ruptures du film support 3 délimitant deux zones de fragilisation 12.
Lors d'une tentative frauduleuse de retirer le module électronique 1 d'un dispositif électronique 100, il y aura rupture du film support 3 au niveau des séries d'encoches 14. Le module électronique 1 sera alors partiellement retiré du dispositif électronique 100, les zones de fragilisation 12 restant fixée audit dispositif électronique 100.

Bien entendus, d'autres motifs et série d'encoches 14 et de zones de fragilisation 12 peuvent être envisagés sans sortir du cadre de la présente invention.

Selon une variante, la ou les zones de fragilisation 12 peuvent être délimitées par une ou plusieurs séries d'encoches 14 non perforantes, c'est-à-dire dont la profondeur est inférieure à l'épaisseur du film support 3.
Un avantage de cette solution est que lorsque la ou les séries d'encoches 14 sont sur la face opposée à celle comportant la ou les zones de contacts électriques 5 du module électronique 1, ces dernières ne sont pas visibles ou pour le moins difficilement décelables depuis la face comportant la ou les zones de contact électrique 5 du module électronique 1.

De préférence, la largeur de la ou des séries d'encoches 14 est ajustée pour être au minimum visible sur le produit final, par exemple d'une largeur entre 50 et 100 µm.

Le procédé de fabrication de modules électroniques 1 selon l'invention, comporte une étape supplémentaire de réalisation de la ou des zones de fragilisation 12 sur le module électronique 1 par rapport au procédé classique de fabrication de modules électroniques bien connu par l'homme du métier.
L'étape de réalisation de la ou des zones de fragilisation 12 sur le module électronique 1, peut être effectuée par découpe laser des séries d'encoches 14.
Un avantage de cette technique est qu'elle peut être réalisée à une cadence élevée, ne ralentissant que légèrement la cadence normale de production, et donc limitant les coûts supplémentaires de production.

Selon une première variante, la réalisation de la ou des zones de fragilisation 12 peut être effectuée lors de la fabrication du film support 3. Dans ce cas, la ou les séries d'encoches 14, délimitant la ou les zones de fragilisation 12, peuvent être perforantes ou non perforantes, et être effectuées sur n'importe quelle face dudit film support 3, selon les contraintes et spécifications demandées.
De préférence, lors de la fabrication du film support 3, l'étape de réalisation de la ou des zones de fragilisation 12 est effectuée à la fin du processus de fabrication afin de limiter le plus possible les actions sur le film support 3 fragilisé.

Selon une autre variante, la réalisation de la ou des zones de fragilisation 12 peut être effectuée lors de la fabrication du module électronique 1. Dans ce cas la ou les séries d'encoches 14 peuvent être perforantes ou non perforantes, et être effectuées sur n'importe qu'elle face du film support 3, selon les contraintes et spécifications demandées.
De préférence, lors de la fabrication du module électronique 1, l'étape de réalisation de la ou les zones de fragilisation 12 est effectuée à la fin du processus de fabrication, c'est-à-dire lorsque la puce électronique 7 a été collée au film support 3 et reliée à la couche de métallisation 5. Cela afin d'éviter la pollution engendrée par la réalisation de la ou les encoches 14, par exemple par un laser.

Selon une variante supplémentaire, la ou les zones de fragilisation 12 peuvent être réalisées au moment de la mise en place du module électronique 1 dans un dispositif électronique 100, comme une carte à puce par exemple.
Selon cette variante, la ou les zones de fragilisation 12 peuvent être réalisées juste avant la mise en place du module électronique 1. Dans ce cas la ou les séries d'encoches 14 peuvent être perforantes ou non perforantes, et être effectuées sur n'importe quelle face du film support 3, selon les contraintes et spécifications demandées.
Une autre possibilité est de réaliser la ou les zones de fragilisation 12 après que le module électronique 1 soit mis en place. Dans ce cas, la ou les séries d'encoches 14 seront alors effectuées sur la face du module électronique 1 comportant la ou les zones de contact électrique 5.
Un avantage de cette dernière possibilité est que dans le cas d'une découpe laser de la ou des séries d'encoches 14, la chaleur dégagée entraine une fusion partielle de l'adhésif retenant le module électronique 1 au dispositif électronique 100, améliorant ainsi la fixation entre ces deux éléments.

Ainsi, en agissant sur la résistance du module électronique en définissant des zones de fragilisations volontaires, il est possible à moindre coût d'obtenir un module électronique sécurisé contre un démontage frauduleux, étant donné qu'une tentative de démontage conduit à la destruction au moins partielle du module électronique et rend ce dernier inopérant et inutilisable ultérieurement.

## Revendications

1. Module électronique sécurisé (1) comportant un film support diélectrique (3) ayant au moins une zone de contact électrique (5) sur une face, et ayant sur la face opposée une puce électronique (7) reliée à ladite au moins une zone de contact électrique (5) par des connectiques (9) passant par des orifices (11) au travers du film support (3), **caractérisé en ce que** ledit film support (3) comporte au moins une zone de fragilisation (12).

2. Module électronique sécurisé (1) selon la revendication 1, **caractérisé en ce que** la délimitation (14) de la au moins une zone de fragilisation (12) est située sur une zone non métallisée (13).

3. Module électronique sécurisé (1) selon la revendication 1, **caractérisé en ce que** la délimitation (14) de la au moins une zone de fragilisation (12) est composée au moins en partie d'une ou plusieurs séries d'encoches (14).

4. Module électronique sécurisé (1) selon la revendication 3, **caractérisé en ce que** la ou les séries d'encoches (14) traversent le film support (3) sur toute son épaisseur.

5. Module électronique sécurisé (1) selon la revendication 3, **caractérisé en ce que** la ou les séries d'encoches (14) ont une profondeur inférieure à l'épaisseur du film support (3).

6. Module électronique sécurisé (1) selon la revendication 3, **caractérisé en ce que** la ou les séries d'encoches (14) ont une largeur de 50 à 100 µm.

7. Module électronique sécurisé (1) selon la revendication 3, **caractérisé en ce que** la ou les séries d'encoches (14) sont réalisées sur la face opposée à la face comportant la ou les zones de contact électrique (5) du film support (3).

8. Module électronique sécurisé (1) selon la revendication 3, **caractérisé en ce que** la ou les séries d'encoches (14) sont réalisées sur la face comportant la ou les zones de contact électrique (5) du film support (3).

9. Module électronique sécurisé (1) selon la revendication 3, **caractérisé en ce que** la ou les séries d'encoches (14) sont réalisées par découpe laser.

10. Dispositif électronique (100) comportant au moins un module électronique sécurisé (1) comprenant un film support diélectrique (3) ayant au moins une zone de contact électrique (5) sur une face, et ayant sur la face opposée une puce électronique (7) reliée à ladite au moins une zone de contact électrique (5) par des connectiques (9) passant par des orifices (11) au travers du film support (3), **caractérisé en ce que** ledit film support (3) comporte au moins une zone de fragilisation (12) fixée audit dispositif électronique (100).

11. Dispositif électronique selon la revendication 9, **caractérisé en ce que** ledit dispositif est une carte à puce (100).

12. Procédé de fabrication d'un module électronique sécurisé (1) comportant un film support diélectrique (3) ayant au moins une zone de contact électrique (5) sur une face, et ayant sur la face opposée une puce électronique (7) reliée à ladite au moins une zone de contact électrique (5) par des connectiques (9) passant par des orifices (11) au travers du film support (3), **caractérisé en ce que** ledit procédé comprend une étape de réalisation d'au moins une zone de fragilisation (12) sur le film support (3).

13. Procédé de fabrication selon la revendication 12, **caractérisé en ce que** l'étape de réalisation d'au moins une zone de fragilisation (12) sur le film support (3) est réalisée lors de la fabrication du film support (3).

14. Procédé de fabrication selon la revendication 12, **caractérisé en ce que** l'étape de réalisation d'au moins une zone de fragilisation (12) sur le film support (3) est réalisée en fin du processus de la fabrication du module électronique (1).

15. Procédé de fabrication d'un dispositif électronique comportant au moins un module électronique sécurisé (1) comprenant un film support diélectrique (3) ayant au moins une zone de contact électrique (5) sur une face, et ayant sur la face opposée une puce électronique (7) reliée à ladite au moins une zone de contact électrique (5) par des connectiques (9) passant par des orifices (11) au travers du film support (3), **caractérisé en ce que** ledit procédé comprend une étape de réalisation d'au moins une zone de fragilisation (12) sur le film support (3).

16. Procédé de fabrication selon la revendication 15, **caractérisé en ce que** l'étape de réalisation d'au moins une zone de fragilisation (12) sur le film support (3) est réalisée avant la mise en place du module électronique (1) dans un dispositif électronique (100), tel qu'une carte à puce.

17. Procédé de fabrication selon la revendication 15, **caractérisé en ce que** l'étape de réalisation d'au moins une zone de fragilisation (12) sur le film support (3) est réalisée après la mise en place du module électronique (1) dans un dispositif électronique (100).
